# EUROPÄISCHE PATENTANMELDUNG

(11) **EP 0 897 116 A1**
(43) Veröffentlichungstag der Anmeldung: **17.02.1999**
(21) Anmeldenummer: 98110968.9
(22) Anmeldetag: 16.06.1998
(51) Int. Cl.: G01R 11/24

(54) **System zur Überwachung von Geräten für die Erfassung und/oder Aufbereitung und/oder Übertragung von abrechnungsrelevanten Verbracuchsgrössen**

(30) Priorität: 13.08.1997 DE 19734989
(71) Anmelder: ITF-EDV Fröschl GmbH, 93194 Walderbach (DE)
(72) Erfinder: Fröschl, Wilfried, D-93152 Etterzhausen (DE); Zintl, Peter, D-93092 Friesheim/Barbing (DE)
(74) Vertreter: Graf, Helmut, Dipl.-Ing.

(57) **Zusammenfassung**

Die Erfindung bezieht sich auf ein neuartiges System zur Überwachung von Geräten für die Erfassung und/oder Aufbereitung und/oder Übertragung von abrechnungsrelevanten Verbrauchsgrößen.

## Beschreibung

Die Erfindung bezieht sich auf ein System zur Überwachung von Geräten für die Erfassung und/oder Aufbereitung und/oder Übertragung von abrechnungsrelevanten Verbrauchsgrößen.

Die ordnungsgemäße Funktion von Geräten, insbesondere auch von Meßgeräten zur Abrechnung von Verbrauchsgrößen, beispielsweise Energieverbrauchsgrößen und dabei speziell zur Messung und Abrechnung des elektrischen Verbrauchs, kann durch Fremdeinwirkung, nämlich Manipulation oder Sabotage (nachstehend generell 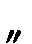 unerlaubter Eingriff) oder aber durch auftretende Fehler gestört werden. Derartige Störungen können zwar in der Regel nicht verhindert werden, es ist aber notwendig, diese Störungen zu erkennen, zu registrieren sowie zu beheben.

Bisher ist es üblich, daß bei Verbrauchszählern zyklisch vor Ort u.a. auch eine Kontrolle des jeweiligen Gerätes (z.B. Zähler oder Zusatzeinrichtung) erfolgt. Dies ist zeitaufwendig und insbesondere dann nicht mehr in dieser Form durchführbar, wenn fernab lesbare Systeme eingesetzt werden.

Aufgabe der Erfindung ist es, ein System aufzuzeigen, mit welchem eine Kontrolle der Geräte Vorort entfallen kann. Zur Lösung dieser Aufgabe ist ein System entsprechend dem Patentanspruch 1 ausgebildet.

Bei dem erfindungsgemäßen System werden von der Überwachungs- und Meldeeinrichtung des jeweiligen Gerätes spontan alle unerlaubten Eingriffe an die Leitstelle gemeldet und dort registriert, so daß von der Leitstelle aus entsprechende Gegenmaßnahmen eingeleitet werden können.

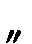 Geräte" im Sinne der Erfindung sind insbesondere auch Meß- und/oder Registrier-und/oder Übertragungsgeräte oder -einrichtungen.

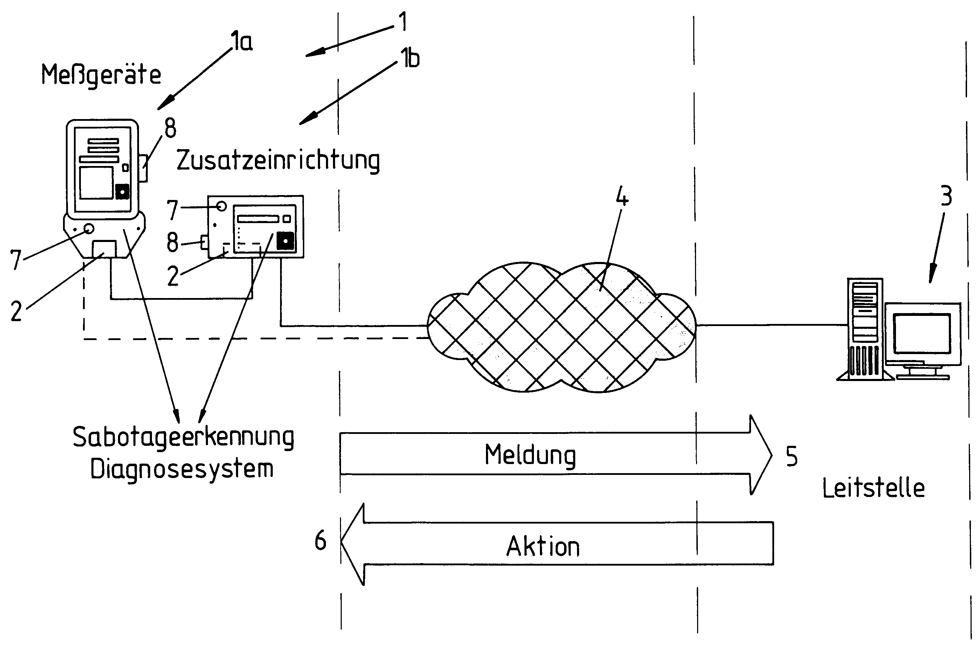

Weiterbildungen der Erfindung sind Gegenstand der Unteransprüche. Die Erfindung wird im Folgenden anhand der Figur an einem Ausführungsbeispiel näher erläutert. Die Figur zeigt sehr schematisch eine Meßstelle oder ein Gerät zum Messen eines Verbrauchs, die über ein Datenübertragungssystem mit einer Leitstelle zusammenwirkt.

Die Erfindung wird zwar im Folgenden an einem System zur Messung der Leistung bzw. des Verbrauchs an elektrische Energie beschrieben. Die Erfindung kann aber auch für andere Energie- oder Verbrauchsarten angewandt werden. Ebenso kann das erfindungsgemäße System auch für externe Zusatzeinrichtungen angewandt werden, die zur Weiterverarbeitung von Energie- oder Verbrauchsgrößen, beispielsweise zu Lastprofilen und/oder zu abrechnungsrelevanten Daten dienen.

In der Figur ist 1a ein Meßgerät zur Messung des Gebrauchs an elektrischer Energie in Form eines herkömmlichen Zählers und 1b eine externe Zusatzeinrichtung, die beispielsweise zur Weiterverarbeitung von Energie- oder Verbrauchsgrößen zu Lastprofilen oder abrechnungsrelevanten Verbrauchsdaten verwendet wird. Beide werden nachstehend allgemein als Gerät 1 bezeichnet.

Das jeweilige Gerät 1 ist mit geräteinternen Mitteln oder Einrichtungen 2 versehen, die u.a. eine Kommunikation bzw. Datenübertragung zwischen dem Gerät 1 und einer von diesen räumlich entfernten Leitstelle 3 des Leistungslieferanten bzw. EVU ermöglichen, und zwar über ein Medium oder Datenfernübertragungssystem 4. Dieses Datenübertragungssystem 4 ist beispielsweise ein Datennetz, z.B. ein privates oder kommerzielles Datennetz oder aber ein öffentliches Datennetz, beispielsweise das Internet. Als Datenübertragungssysteme eignen sich grundsätzlich auch Mobilfunk-Netze oder Mobil-Telefon-Netze sowie alle Medien, die eine Datenfernübertragung ermöglichen.

Das Gerät bzw. dessen Einrichtung 2 sind so ausgeführt, daß unter bestimmten Bedingungen automatisch Meldungen über das Datenübertragungssystem 4 an die Leitstelle 3 abgesetzt werden (Pfeil 5). Weiterhin ist jedes Gerät auch so ausgeführt, daß es über das Datenübertragungssystem 4 Daten, insbesondere Informationen und Befehle von der Leitstelle 2 empfangen und, soweit es sich um Befehle handelt, auf diese entsprechend reagierend können (Pfeil 6).

Die Einrichtungen 2 der Geräte 1 dienen insbesondere auch der Erkennung und Meldung von Manipulationen und Sabotageversuchen(unerlaubter Eingriffe), d.h. beim Erkennen solcher Manipulationen oder Sabotageversuche werden spontan entsprechende Meldungen automatisch an die Leitstelle 3 bzw. an den dortigen Rechner übermittelt, wobei die hierbei übermittelten Daten beispielsweise enthalten:
- Identifikation des jeweiligen Gerätes 1;
- Uhrzeit und Datum des unerlaubten Eingriffs;
- Art des unerlaubten Eingriffs sowie
- Übertragung sämtlicher relevanter Daten, insbesondere auch der verbrauchs-und abrechnungsrelevanten Daten aus dem Gerät 1 an die Leitstelle 3.

Die so übertragenen Daten ermöglichen es, einen unzulässigen Eingriff sofort anzuzeigen, insbesondere diesen auch hinsichtlich Zeit und Art zu erfassen bzw. zu rekonstruieren. Durch die Meldung an der Leitstelle 3 ist es weiterhin auch möglich, von der Leitstelle aus die notwendigen Gegenmaßnahmen zu veranlassen.

Die Einrichtungen 2 zur Erkennung und Meldung von unerlaubten Eingriffen arbeiten mit Sensoren zusammen, die in der Figur allgemein mit dem Sensor 7 angegeben sind. Tatsächlich sind aber zur Erfassung solcher Eingriffe am Gerät 1 verschiedenste Sensoren oder Fühler vorgesehen:

### Gehäusezugangssensoren:

Hier handelt es sich um Sensoren, die das unbefugte Öffnen und/oder Entfernen und/oder Zerstören des Gehäuses, von Gehäuseabdeckungen und/oder Gehäuseteilen registrieren und eine entsprechende Meldung an die Leitstelle 3 veranlassen.

Hierfür eignen sich beispielsweise Licht-Sensoren oder Lichtschranken, die z.B. derart ausgeführt sind, daß beim Entfernen eines Gehäusedeckels oder Gehäuseteils die Lichtstrecke einer solchen im Gehäuse ausgebildeten Lichtschranke unterbrochen wird.

Weiterhin eignen sich hier u.a. auch magnetische Überwachungskreise, wobei z.B. an dem zu überwachenden Gehäusedeckel oder Gehäuseteil ein magnetisches Element vorgesehen ist oder das überwachende Gehäuseteil als ein solches Element wirkt, welches beim Entfernen die Größe eines im Gehäuse untergebrachten magnetischen Kreises verändert, beispielsweise die Induktivität einer im Gehäuse untergebrachten elektrischen Spule usw..

Möglich sind weiterhin auch galvanische Überwachungskreise, beispielsweise ein hoher Stromkreis im Inneren des Gehäuses, der beim Entfernen eines Gehäuseteils oder Gehäusedeckels unterbrochen wird.

Weiterhin ist es insbesondere auch möglich solche Komponenten des Gerätes 1, die besonders sensibel und/oder besonders sabotage- und/oder manipulationsgefährdet sind, in einem nach außen hin abgedichteten Gehäuse unterzubringen, in welchem ein gewisser Überdruck herrscht, der von einem Drucksensor überwacht wird, der bei einem unbefugten Eingriff bzw. Öffnen ein entsprechendes Signal an die Leitstelle 3 veranlaßt.

### Sensoren zur Erfassung von unzulässigen Einwirkungen oder Eingriffen insbesondere an Meßwerken:

Insbesondere zur Registrierung von unzulässigen Eingriffen an dem Meßwerk des Zählers 1 durch starke äußere Magnetfelder sind auf diese Magnetfelder ansprechende Sensoren im Inneren des Gehäuses vorgesehen, und zwar beispielsweise Hallsensoren, die in den drei Raumachsen orientiert sind und mit denen übernatürlich starke Magnetfelder detektiert werden.

Weiterhin können im Inneren des Gehäuses des Gerätes 1 auch Detektoren vorgesehen sein, mit denen äußere Energiefelder, d.h. beispielsweise übernatürlich starke elektromagnetische Felder erfaßt werden.

### Erfassung unerlaubter Rückstellungen oder Einstellungen des Gerätes 1:

Zur Registrierung von unerlaubten Rückstellungen oder unerlaubten Änderungen von Einstellungen ist das Gerät 1 so ausgeführt, daß erlaubte Rückstellungen oder erlaubte Änderungen von Einstellungen nur innerhalb eines definierten Zeitbereichs und/oder nur dann möglich sind, wenn von der Leitstelle 3 eine entsprechende Freigabe durch Übertragung eines entsprechenden Signals vorliegt.

Bei der dargestellten Ausführungsform besitzt das Gerät 1 jeweils eine Schnittstelle 8, an die Meßwertabfrage- und/oder Service-Einrichtungen angeschlossen werden können, wobei der Zugang über diese Schnittstellen 8 durch ein Paßwort geschützt ist. Der Zugang über die Schnittstelle 8 wird jeweils registriert und die entsprechenden Daten werden über das Datenübertragungssystem 4 an die Leitstelle 3 übertragen, und zwar wiederum zumindest:
- Identifikation des Gerätes 1;
- Zeit und Datum des Zugangs;
- Dauer des Zugangs über die Schnittstelle 8;
- verwendetes Paßwort.

Ebenso wird bei jedem Zugangsversuch mit falscher Paßwortangabe eine Meldung an die Leitstelle 3 veranlaßt, die (Meldung) beispielsweise wiederum zumindest folgende Elemente enthält:
- Identifikation des Gerätes 1;
- Zeit und Datum des Zugangs;
- Dauer des Zugangs über die Schnittstelle 8;
- verwendetes Paßwort.

### Weitere unerlaubte Manipulation an Meßeinrichtungen bzw. Meßwerken:

Mit einem in dem jeweiligen Gerät 1 vorhandenen Zeitnormal (beispielsweise Funkuhrempfänger (DCF77) werden auch Zeit- oder Gangfehler der Systemzeit des Meßgerätes überwacht. Treten größere Fehler in der Systemzeit auf, so kann dies durch einen Funktionsfehler, aber auch durch einen unbefugten Eingriff verursacht sein, und es wird daher eine entsprechende Meldung an die Leitstelle 3 abgesetzt.

Um eine Überwachung und Übermittlung von Meldungen an die Leitstelle 3 bei jedem unerlaubten Eingriff, auch bei einem Ausfall der Netz- oder Systemspannung zu erreichen, ist das Gerät 1 jeweils mit einer Batterie ausgestattet.

Vorstehend wurde davon ausgegangen, daß bei unerlaubten Eingriffen von dem jeweiligen Gerät 1 selbsttätig entsprechende Meldungen an die Leitstelle 3 veranlaßt werden. Es besteht weiterhin aber auch die Möglichkeit, daß die Leitstelle 3 durch Übermittlung entsprechender Befehle (Pfeil 6) eine Selbstprüfung eines Gerätes 1 veranlaßt, und zwar insbesondere eine Überprüfung sämtlicher Funktionskomponenten und Überwachungs-Sensoren auf ihre Funktionstüchtigkeit hin überprüft werden. Eventuelle Fehlfunktionen werden dann wiederum mit der entsprechenden Geräte-Identifikation an die Leitstelle 3 bzw. den dortigen Rechner übermittelt und dort abgespeichert. Bei der Überprüfung der Systemkomponenten werden beispielsweise beim Zähler 1a u.a. überprüft:
- Systemspannung (Phasenausfall)
- Zustand von Versorgungseinrichtungen (Batterie, ...)
- Zustand und Inhalt von Speichermedien (Meßwertspeicher)
- Ringspeicher
   Meßeinrichtungen sind vielfach mit einem Ringspeicher ausgerüstet, der die Meßgrößen über einen vorgegebenen Zeitraum aufzeichnet, damit diese dann an weiter verarbeitende Systeme übertragen werden. Hierbei ist erforderlich, daß der 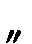 Überlauf" eines solchen Ringspeichers rechtzeitig erkannt und gemeldet wird, um Fehlfunktionen zu vermeiden. Bevor ein derartiger Überlauf stattfindet, erfolgt eine entsprechende Fehlermeldung an die Leitstelle 3.
- Zeit- oder Gangfehler
   Überprüft werden weiterhin auch mögliche Zeit- oder Gangfehler der Meßeinrichtung bzw. des jeweiligen Zählers 1. Als Vergleichsnormal wird bei dieser Prüfung beispielsweise ein im Gerät vorhandenes Zeitnormal verwendet, z.B. quarzgesteuerter Taktgeber oder Funkuhr (DCF77). Grundsätzlich besteht bei der Überprüfung aber auch die Möglichkeit, bei dieser Überprüfung ein in der Leitstelle 3 vorhandenes Zeitnormal (z.B. quarzgesteuerter Taktgeber oder DCF77-Empfänger) zu verwenden.

Die Erfindung wurde voranstehend an Ausführungsbeispielen erläutert. Es versteht sich, daß zahlreiche Änderungen sowie Abwandlungen möglich sind, ohne daß dadurch der der Erfindung zugrundeliegende Erfindungsgedanke verlassen wird.

### Bezugszeichenliste

- 1: Gerät
- 1a, 1b: Zähler bzw. Zusatzgerät
- 2: Erfassungs- und Meldeeinrichtung
- 3: Leitstelle
- 4: Datenübertragungssystem
- 5: Meldungen an die Leitstelle
- 6: Meldungen oder Befehle der Leitstelle
- 7: Sensor
- 8: Schnittstelle

## Patentansprüche

1. System zur Überwachung von Geräten (1) für die Erfassung und/oder Aufbereitung und/oder Übertragung von abrechnungsrelevanten Verbrauchsgrößen, **gekennzeichnet** durch Überwachungs- und Meldeeinrichtungen (2) in den Geräten, die (Überwachungs- und Meldeeinrichtungen) bei jedem unerlaubten Eingriff am jeweiligen Gerät (1) eine entsprechende Meldung generieren, und durch wenigstens eine Leitstelle (3), die über ein Datenfernübertragungs-Medium (4) einer Vielzahl von Geräten zugeordnet ist und an die bei jedem unerlaubten Eingriff über dieses Medium (4) die entsprechende Meldung übertragen wird.

2. System nach Anspruch 1, dadurch gekennzeichnet, daß das Medium (4) zur Datenfernübertragung ein öffentliches, privates und/oder kommerzielles Datennetz ist.

3. System nach Anspruch 1 oder 2, dadurch gekennzeichnet, daß die Überwachungs-und Meldeeinrichtungen (2) auch zum Empfang von Befehlen über das Medium (4) sowie zum Ausführen solcher Befehle ausgebildet sind.

4. System nach einem der vorhergehenden Ansprüche, dadurch gekennzeichnet, daß die Überwachungs- und Meldeinrichtungen (2) jeweils wenigstens einen Sensor (7) zum Melden eines unbefugten Öffnens des Gehäuses oder von Gehäuseteilen des Gerätes und/oder zur Beaufschlagung des Gerätes mit äußeren Signalen und/oder Feldern und/oder zur Erfassung von Änderungen und/oder Manipulationen eines Zählerstandes aufweisen.

5. System nach einem der vorhergehenden Ansprüche, dadurch gekennzeichnet, daß die Überwachungs- und Meldeeinrichtungen (2) auch den Zugang über Schnittstellen (8) des jeweiligen Gerätes überwachen und bei jedem Zugang und/oder bei einem nicht erlaubten Zugangsversuch, beispielsweise bei einem Zugangsversuch mit falschem Paßwort, eine Meldung an die Leitstelle (3) absetzen.

6. System nach einem der vorhergehenden Ansprüche, dadurch gekennzeichnet, daß durch Befehle der Leitstelle (3) die Überwachungs- und Meldeeinrichtungen (2) eine Überprüfung der Systemkomponenten und/oder Funktionen des jeweiligen Gerätes (1) veranlassen und die entsprechenden Meßdaten die Leitstelle (3) übermitteln.
